# EUROPÄISCHE PATENTSCHRIFT

(11) **EP 1 287 063 B1**
(45) Veröffentlichungstag und Bekanntmachung des Hinweises auf die Patenterteilung: **16.03.2005**
(21) Anmeldenummer: 01944932.1
(22) Anmeldetag: 16.05.2001
(51) Int. Cl.: C08K 5/3435, C08K 5/17, H01L 33/00, C08L 63/00

(54) **ALTERUNGSSTABILE EPOXIDHARZSYSTEME, DARAUS HERGESTELLTE FORMSTOFFE UND BAUELEMENTE UND DEREN VERWENDUNG**
EPOXY-RESIN SYSTEMS, WHICH ARE RESISTANT TO AGEING, MOULDING MATERIALS AND COMPONENTS PRODUCED THEREFROM AND THE USE THEREOF
SYSTEMES DE RESINE EPOXY RESISTANT AU VIEILLISSEMENT, MATERIAUX A MOULER ET COMPOSANTS REALISES A PARTIR DE CES SYSTEMES, AINSI QUE LEUR UTILISATION

(30) Priorität: 31.05.2000 DE 10027206
(43) Veröffentlichungstag der Anmeldung: 05.03.2003
(73) Patentinhaber: Osram Opto Semiconductors GmbH, 93049 Regensburg (DE)
(72) Erfinder: BOGNER, Georg, 93138 Lappersdorf (DE); BRUNNER, Herbert, 93047 Regensburg (DE); HÖHN, Klaus, 82024 Taufkirchen (DE)
(74) Vertreter: Epping Hermann & Fischer
(86) Internationale Anmeldenummer: PCT/DE2001/001848
(87) Internationale Veröffentlichungsnummer: WO 2001/092396

(56) Entgegenhaltungen:
- EP-A- 0 400 898
- EP-A- 0 507 333
- DE-A- 3 241 767
- US-A- 4 033 928

## Beschreibung

Zum Schutz gegen Umgebungseinflüsse werden elektrische und elektronische Bauelemente mit Reaktionsharzen durch Gießharzanwendungen vergossen beziehungsweise verkapselt. Erreicht werden soll dabei ein Schutz gegen mechanische, chemische und klimatische Umgebungseinflüsse, insbesondere ein Schutz gegen Stöße, gegen Bruch, gegen aggressive Chemikalien und gegen Feuchtigkeit, wobei dieser Schutz auch bei hohen Umgebungstemperaturen, die im Motorbereich eines Automobils bis cirka 130 Grad betragen können, aufrecht erhalten werden muß. Besonderen Belastungen sind optoelektronische Bauelemente, insbesondere lichtemittierende Bauelemente wie Leuchtdioden (LED) ausgesetzt, bei denen eine zusätzliche Strahlenbelastung des zur Verkapselung eingesetzten Harzsystems durch die LED selbst erfolgt. Neben der chemischen und mechanischen Festigkeit sowie einer hohen Verbundfestigkeit zu unterschiedlichen Substraten muß ein solcher Reaktionsharzformstoff zusätzlich noch eine hohe Transparenz bei einem Brechungsindex n_{D} von möglichst größer 1,5 sowie eine Lichtbeständigkeit bezüglich Eintrübung, Versprödung oder Vergilbung aufweisen. Das Problem der erhöhten Strahlenbelastung lichtemittierender Halbleiterbauelement wächst dabei vor allem mit abnehmender Wellenlänge, zunehmender Strahlungsdosis des Bauelements sowie durch die Zunahme der Strahlungsintensität bei längerwellig emitierenden sogenannten High-Power-LEDs, und führt beispielsweise bei blauemittierenden Halbleiterbauelementen dazu, daß für deren Verkapselung noch kein befriedigendes alterungsstabiles Harzsystem aufgefunden werden konnte.

Im Handel befindliche LEDs werden gegenwärtig mit zweikomponentigen thermisch vernetzenden Reaktionsharzen auf der Basis von Epoxiden mit Anhydriden als Härter vergossen. Diese Stoffe sind reologisch optimiert und weisen thermisch reaktive Eigenschaften auf, die eine rationelle Massenfertigung erlauben. Die Epoxidharzkomponente (A-Komponente) dieser zweiteiligen Reaktionsharzsysteme besteht dabei aus einem nieder- bis mittelviskosen Bisphenol-A-Diglycidylether und reaktivem Epoxidverdünner beziehungsweise mehrfachfunktionellen Epoxynovolak-Harzen sowie aus für Gießharzen bekannten Zusatz- und Hilfsstoffen. Für die Verwendung bei LEDs kann die A-Komponente außerdem mit organischen Farbstoffen eingefärbt sein. Diffus lichtemittierende Bauelemente können spezielle Diffusorpasten auf der Basis anorganischer Pigmente aufweisen. Mit Hilfe spezifischer Metallsalzbeschleuniger mit organischen Carboxylat- und Alkoholatanionen oder Liganden können zweikomponentige Reaktionsharzsysteme auf Anhydrid/ Epoxidbasis angehärtet werden. Zur Verkapselung optoelektronischer Bauelemente befinden sich auch zweikomponentige Anhydrid/Epoxid-Gießharzmassen auf der Basis cycloaliphatischer Epoxidharze und deren Abmischungen mit Glycidylether- und Glycidylesterharzen im Einsatz. In Sonderfällen werden auch Kapselmassen auf Acrylbasis verwendet.

Es zeigt sich jedoch, daß die bekannten Vergußmassen nicht ausreichend alterungsstabil ausgebildet sind, um die stetig anspruchsvoller werdenden Anforderungen für die Verkapselung von insbesondere lichtstarken LEDs zu erfüllen. Sie zeigen noch innerhalb der Lebensdauer der Bauelemente Eintrübungen, Vergilbungserscheinungen und können eine Sprödigkeit und damit eine zunehmende Porösität sowie Cracks, Risse und eine verminderte Verbundfestigkeit zum lichtemittierenden Bauelement mit Delamination aufweisen. Gießharzformstoffe mit derartigen Schädigungen ergeben bei Bauelementen der Optoelektronik aber eine verminderte Lichtausbeute mit verminderten optischen Strahlungscharakteristiken und sind daher für Bauelemente mit dauerhaft oder kundenspezifischen konstantem Betrieb nicht geeignet.

Aufgabe der vorliegenden Erfindung ist es daher, Reaktionsharzsysteme zur Verkapselung von Bauelementen und insbesondere von optoelektrischen Bauelementen anzugeben, die eine erhöhte Alterungsstabilität bei Strahlungsbelastung aufweisen, möglichst ohne dabei die übrigen Eigenschaften der Reaktionsharzsysteme beziehungsweise der daraus hergestellten Formstoffe zu beeinträchtigen.

Diese Aufgabe wird erfindungsgemäß durch ein Epoxidharzsystem mit dem Merkmal von Anspruch 1 gelöst. Vorteilhafte Ausgestaltungen der Erfindung sowie daraus hergestellte Bauelemente gehen aus weiteren Ansprüchen hervor.

Das erfindungsgemäße Epoxidharzsystem ist für Gießharzanwendungen, Verguß- und Kapselmassen sowie für Lacke geeignet. Es zeigt eine wesentlich verbesserte Beständigkeit gegen Formstoffalterung bei zusätzlicher Strahlenbelastung. Da insbesondere die Entstehung von Eintrübungen, Rissen und Cracks verhindert wird, ergibt sich damit auch eine verbesserte Witterungsbeständigkeit, da die genannten Lichtalterungserscheinungen zu einer zunehmenden Feuchteunbeständikeit von damit vergossenen, verkapselten oder versiegelten Gegenständen, insbesondere Bauelementen führen.

Das Epoxidharzsystem kann eine A-Komponente mit einem Epoxidharz und eine B-Komponente mit einem Härter umfassen, üblicherweise ein Carbonsäureanhydrid. Neben diesen Grundbestandteilen kann das Epoxidharzsystemes weitere für die jeweilige Anwendung geeignete und für sich bekannte weitere Bestandteile aufweisen

Überraschend hat sich gezeigt, daß ein als Stabilisator zugesetzes sterisch gehindertes Amin eine gute Verträglichkeit mit der A-Komponente aufweist und die Lagerbeständigkeit der A-Komponente nicht beeinträchtigt. Es werden lagerstabile A-Komponenten und damit auch Reaktionsharz-Systeme erhalten, die bis zu mehreren Monaten unverändert bei der Bearbeitung - Mischen, Dosieren/Applizieren, Härten - und den Eigenschaften lagerfähig sind, die zu Formstoffen mit ansonsten unveränderten Eigenschaften aber deutlich verbesserter Alterungsstabilität unter Temperatur-, Feuchte- und Strahlenbelastung führen. Die erhaltenen Formstoffe können wasserklar transparent hergestellt werden, zeigen eine äußerst geringe Neigung zur Vergilbung, zur Eintrübung oder zum spröde werden. Dies ist auf die positive und lichtstabilisierende Wirkung des sterisch gehinderter Amin zurückzuführen, welche unter dem Namen HALS (Hindered Amine Light Stabilizers) bereits als Lichtstabilisatoren für die Verwendung in thermoplastischen Polyolefinkunststoffen bekannt waren. Aminen und deren Derivate sind als Härter und als Härtungsbeschleuniger für Reaktionsharzsysteme bekannt und liefern üblicherweise gefärbte und stark zur Vergilbung neigende Formstoffe. Überraschend ist daher, daß trotz dieser von Aminen bekannten Wirkung dennoch mit sterisch gehinderten Aminen ein lagerstabile Reaktionsharzsysteme erhalten werden. Es wird vermutet, daß die sterische Abschirmung des freien Elektronenpaars am Stickstoffatom des Amins sowie die reduzierte Basizität der Verbindungen dafür sorgt, daß die Reaktionsharzeigenschaften für die Verwendung in großvolumigen Fertigungsprozessen und so die Reaktionsharzeigenschaften nicht negativ beeinflusst werden.

Das sterisch gehinderte Amin ist eine Aminoxidalkylverbindung, welches von insbesondere sterisch voluminösen Gruppen für chemische Reaktionen abgeschirmt ist. Sterisch anspruchsvolle Gruppen können Substituenten sein, die in Alphastellung zum Stickstoff tertiare Kohlenstoffatome mit sterisch anspruchsvollen aliphatischen, cycloaliphatischen und aromatischen Substituenten aufweisen. Sterisch anspruchsvolle Amine sind auch heterocyclische Amine, die vorzugsweise ebenfalls in Alphastellung eine sterische Abschirmung erfahren.

Die Aminoxidalkylverbindungen haben die allgemeine Zusammensetzung (R1) (R2) N-R3, bei den R1 und R2 unabhängig von einander für Alkyl, Aryl oder Alkylaryl stehen oder bei denen R1 und R2 zusammen ein zweiwertiger Substituent ist, der zusammen mit dem Stickstoffatom einen Cyclus oder Heterocyclus bildet und R3 einen Alkoxyrest mit 1-18C-Atomen bedeutet, der zusätzlich noch eine oder zwei funktionelle Gruppen mit Ausnahme von NH aufweisen kann.

Diese Aminoxidalkylverbindungen zeigen eine besonders niedrige Basizität, die einerseits aufgrund der sterischen Abschirmung des freien Elektronenpaars und andererseits durch die induktive Wirkung des Sauerstoffs herabsetzt ist. Diese Amine zeigen eine besonders gute Verträglichkeit mit Epoxid-A-Komponenten. Bei der Härtung der Reaktionsharzsysteme sind sie ohne negativen Einfluß auf die Härtungsreaktion und führen zu Gießharzformstoffen, in denen das Amin zwar nicht chemisch eingebunden aber aufgrund aufgrund möglicher Wasserstoffbrückenbindungen im Netzwerk sowie aufgrund eines relativ hohen Molgewichts dennoch sicher gegen Ausdampfung eingelagert ist. Die Formstoffe sind wasserklar/transparent und zeigen eine deutlich verbesserte Alterungsstabilität in feuchter Umgebung bei Temperaturen oberhalb 100°C und bei zusätzlicher Strahlenbelastung.

Für die Erfindung ist es ausreichend, das als Stabilisator verwendete Amin in geringem Anteil in die A-Komponente einzumischen, wobei ein Anteil von 0,1 bis 5,0 Gewichtsprozent, vorzugsweise von 0,1 bis 1,0 Gewichtsprozent ausreichend ist. Als Härterkomponente oder B-Komponente wird ein Anhydrid eingesetzt, welches vorzugsweise von einer cycloaliphatischen oder aromatischen Di- oder Tetracarbonsäure abgeleitet ist. Sie kann das Anhydrid der Carbonsäure als Hauptbestandteil und gegebenenfalls saure Ester enthalten, die durch teilweise Umsetzung dieser Anhydride mit aliphatischem Alkohol erhalten werden.

Die B-Komponenten können phosphorhaltige Oxidationsstabilisatoren beinhalten. Für optoelektronische Anwendungen werden vorzugsweise Metallsalze als Beschleuniger eingesetzt.

Das Epoxidharzsystem ist sehr gut für Gießharzanwendungen geeignet und zeigt bei Verarbeitungstemperatur eine ausreichend niedrige Viskosität, gute Benetzungseigenschaften mit einer ausreichenden Verarbeitungsdauer und läßt sich schlieren- und blasenfrei applizieren. Es umfaßt eine epoxidhaltige A-Komponente und eine Anhydrid als Härter enthaltende B-Komponente. Die A-Komponente enthält mehr als 60 Gewichtsprozent eines Epoxids auf der Basis eines Glycidylethers oder Glycidylesters sowie das sterisch gehinderte Amin als Stabilisator gegen Formstoffalterung bei zusätzlicher Strahlenbelastung.

Bei der Erfindung ist es vorteilhaft, in der A-Komponente als weiteren Stabilisator ein sterisch gehindertes Phenolderivat einzusetzen. Dieses stabilisiert den Gießharzformstoff gegen thermo-oxidative Angriffe.

Als Epoxid ist in der A-Komponente vorzugsweise ein Diglycidylether, ein Diglycidylester oder ein cycloaliphatisches Epoxid oder eine Mischung davon als Hauptbestandteil enthalten.

Bevorzugt sind Diglycidylether von Bisphenol A und als Nebenbestandteil ein mehrfunktionelles Epoxynovolakharz in zusammen mehr als 80 Gewichtsprozent Anteil enthalten.

Weiterhin können für Gießharze übliche Zusätze enthalten sein, welche ausgewählt sind aus Reaktivverdünner, insbesondere auf Basis von Monoglycidylether, Alkohol, Haftvermittler, Verlaufshilfsmittel, Entlüfter, optischer Aufheller, Lichtabsorber, Trennmittel oder Thixotropiermittel. Insgesamt ergeben sich damit für erfindungsgemäße Gießharzsyteme für die A-Komponente folgende Zusammensetzungen, die in der folgenden Tabelle durch die jeweiligen Grenzwerte angegeben sind:

| | |
|---|---|
| Epoxidharze auf Glycidylether- oder Glycidylesterbasis sowie cycloaliphatische Epoxidharze | > 50 % |
| Epoxynovolak | < 40 % |
| Reaktivverdünner (Monoglycidylether) | < 10 % |
| Alkohol | < 10 % |
| Sterisch gehindertes Amin | < 5, 0 % |
| Oxydationsstabilisator | < 5,0 % |
| Haftvermittler | < 5,0 % |
| Lichtabsorber | < 0,5 % |
| Verlaufshilfsmittel auf Silikonbasis | < 1,0 % |
| Entlüfter auf Silikonbasis | < 1,0 % |
| Optischer Aufheller | < 1,0 % |
| Internes Trennmittel für das Gehäuse | < 1,0 % |
| Thixotropiermittel | < 10 % |
| Diffusor (Anorganische Partikel) | < 30 %. |
| Organische Farbstoffe/Pigmente | < 10 % |
| Anorganische Leuchtstoffe | < 40 % |

Mit den Glycidylethern als Hauptbestandteil lassen sich Gießharzformstoffe mit hohen Glasübergangstemperaturen von 110 und in einem Ausführungsbeispiel von 130 Grad Celsius und mehr herstellen, die die erfindungsgemäße hohe Alterungsstabilität aufweisen. Die Diglycidylether weisen vorzugsweise auch reduzierte Chlorgehalte auf, was sich weiterhin positiv auswirkt und insbesondere eine niedrigere Tendenz zur Vergilbung des Gießharzformstoffes und für die Formstoffe eine geringere Delamination bewirkt. Erfindungsgemäße Epoxidgießharzsysteme weisen Chlorgehalte auf, die an hydrolisierbarem Chlor weniger als 250 ppm enthalten und die einen Gesamtchlorgehalt von weniger als 1000 ppm besitzen.

Bei der Härtung des Epoxidharzsystems werden möglichst stöchiometrische Mengen an A- und B-Komponente eingesetzt, da dies für das Verhalten gegenüber Feuchtigkeit sowie für die elektrischen Kenndaten im Bauelement vorteilhaft ist. Bezogen auf die A-Komponente werden 0,7 bis 1,2 Reaktionsäquivalente an B-Komponente eingesetzt. In die an die Massenfertigung angepassten Prozesse werden jedoch vorzugsweise Epoxidharzsysteme eingesetzt, bei denen die B-Komponente im Unterschuß vorliegt und vorzugsweise 0,7 bis 0,9 Reaktionsäquivalente ausmacht. Dabei ist die Eigenreaktion der Epoxide sowie ein gewisser Anteil an Hydrolyse-berücksichtigt, so daß insgesamt ein stöchometrischer Umsatz reaktiver Epoxidgruppen mit den entsprechenden Anhydridgruppen stattfinden kann. Die damit hergestellten Formstoffe zeigen eine niedrige Feuchteaufnahme sowie eine hohe thermische und thermomechanische Stabilität. Dies macht die Gießharzformstoffe auch zur Verwendung für SMD-Bauelemente, - oberflächenmontierbare Bauelemente - geeignet, da diese in einem Lötprozess erhöhten Temperaturen mit ausgeprägten Temperaturprofilen ausgesetzt werden. Die niedrige Feuchteaufnahme sowie eine Glasübergangstemperatur über 130°C machen die Gießharzformstoffe zur Verwendung im Automobilbereich geeignet. Die hohe Transparenz und Alterungsstabilität bezüglich der optischen Eigenschaften macht die Gießharzformstoffe insbesondere zur Verwendung in der Optoelektronik und insbesondere zur Verkapselung von optoelektronischen Bauelementen wie beispielsweise LEDs geeignet. Die hohe photochemische Stabilität der Gießharzformstoffe erlaubt den Einsatz der Epoxidharzsysteme zum Vergießen von leuchtstarken lichtemittierenden Halbleiterbauelementen, insbesondere solchen mit Emissionswellenlängen kleiner 500 nm. Damit sind sie zum Vergießen von blauemittierenden LEDs geeignet, vorzugsweise in Kombination mit lumineszenzkonvergierenden Stoffen. Diese werden dem Epoxidharz zugemischt, sodaß aus dem blauen Licht des Halbleiterelements eine weißleuchtende LED durch Lumineszenzkonversion geschaffen werden kann.

Ein weiterer Vorteil, der sich insbesondere durch den Einsatz von chlorärmeren hydroxylfreien Epoxidbasisharzen ergibt, liegt in der niedrigeren Feuchteaufnahme, einem deutlich erniedrigten E-Modul und einem niedrigeren thermischen Ausdehnungskoeffizienten bei nahezu unveränderter Glasübergangstemperatur. Wird mit dem erfindungsgemäßen Epoxidharzsystem ein lichtemittierendes Bauelement verkapselt, so reduziert sich dadurch der thermomechanische Streß, den die Verkapselung auf das Bauelement ausübt. Somit ist auch die Gefahr einer mechanisch bedingten Bauelementdegradation weiter herabsetzt, und die Gesamtpackage weiter stabilisiert. Außerdem wird mit dem niedrigen Chlorgehalt des zum Verguß verwendeten Epoxidharzsystems der Korrosion von korrodierbaren Strukturen auf dem Bauelement entgegengewirkt. Dafür ist vor allem der niedrige Gehalt an hydrolysierbarem Chlor entscheidend. Im Langzeitklimatest mit vergleichbaren chlorhaltigen Harzsystemen hat sich gezeigt, daß unter verschärften Temperatur/Feuchtebedingungen unter Strombelastung Chloridion und chlorhaltige Spezies freigesetzt werden können, die zu Eintrübungen an der Grenzfläche zwischen dem Chip des Halbleiterbauelements und der Vergußmasse führen können. Dadurch nimmt bei lichtemittierenden Bauelementen die Leuchtstärke ab. Außerdem können Hydrolysevorgänge wie die von Chlor die Haftfestigkeit zum Chip soweit vermindern, daß eine Delamination an der Grenzfläche Vergußmasse-Chip eintritt, die die Leuchtstärke weiter herabsetzt. Bezüglich der Feuchtestabilität erfindungsgemäßer Epoxidharzsysteme wurde gefunden, daß die Gießharzformstoffe auf Basis hydroxylfreier Bisphenol-A-Epoxidharze bei Feuchteaufnahme einen geringen Abfall der Glasübergangstemperatur um nur wenige Grad C aufweisen, der deutlich geringer ist, als bei herkömmlichen Vergußmassen.

Ein weiterer vorteilhafter Bestandteil erfindungsgemäßer Epoxidharzsysteme, sind Lichtschutzmittel insbesondere in der A-Komponente. Diese absorbieren energiereiche elektromagnetische Strahlen und geben die Energie nach strahlungsloser Deaktivierung wieder ab. Solche Lichtschutzverbindungen beispielsweise vom Benzophenontyp oder auf der Basis von Triazinen sind für Thermoplaste bereits bekannt. Die erfindungsgemäß zugesetzten Absorber sind so ausgewählt, daß daß für längerwelliges Licht über 420 nm keine Absorption erfolgt.

Um die Absorption der zu nützenden Strahlung durch die Lichtschutzmittel gering zu halten, wird auch deren Konzentration beziehungsweise Anteil in der A-Komponente möglichst niedrig eingestellt. Eine vorteilhafte Konzentration von Lichtschutzmittel in einem Epoxidharzsystem, das für transparente Verkapselungen von optoelektronischen Bauelementen eingesetzt wird, liegt bei weniger als 0,2 Gewichtsprozent.

Im Folgenden wird die Erfindung anhand von Ausführungsbeispielen und der dazugehörigen Figur näher erläutert.

Die Figur zeigt im schematischen Querschnitt eine an sich bekannte LED mit einer Gießharzverkapselung.

Es werden fünf verschiedene A-Komponenten angegeben, wobei die Ausführungsbeispiele eins und zwei vorteilhafte Grundzusammensetzungen darstellen, zu denen in den Ausführungsbeispielen drei, vier und fünf jeweils sterisch gehinderte Amine beziehungsweise sterisch gehinderte Phenole zugegeben werden. Für alle fünf Ausführungsbeispiele wird die gleiche B-Komponente verwendet und zwar ein mit saurem Ester modifiziertes Methylhexahydrophthalsäureanhydrid. Der saure Ester ist ein Formulierungsbestandteil des Härters, bei dem bis zu 50% der difunktionellen Anhydridgruppe mit ein- und mehrwertigen Alkoholen zu einem Halbester umgesetzt werden. Hexahydrophthalsäure ist ein für optoelektronische Anwendungen vorteilhaft einzusetzendes Basisanhydrid.

Mit den Epoxidharzsystemen der Ausführungsbeispiele eins bis fünf werden Formkörper hergestellt und ausgehärtet, die anschließend auf ihre thermomechanischen Eigenschaften sowie auf die Klimabeständigkeit und insbesondere die Feuchtkeitsaufnahme untersucht werden. Weiterhin werden mit den Epoxidharzsystemen blauemittierende LEDs vergossen. Die Alterungsstabililät der LEDs wird im Dauerbetrieb anhand der emittierten Lichtintensität bestimmt.

Von Aminen wird allgemein angnommen, daß diese zum Gelieren der Epoxidharzkomponente führen und daher üblicherweise keine Verwendung als Formulierungsbestandteil in lagerfähigen Epoxid-A-Komponenten finden. Die verminderte Reaktivität Aminstabilisatoren im Epoxidharz beruht im Wesentlichen darauf, daß die reaktive Aminfunktion durch sterisch anspruchsvolle Seitengruppen abgeschirmt wird. Durch die gezielte Auswahl elektronenziehender Gruppen, die entweder direkt am Amin-Stickstoff gebunden sind oder zu diesem in β-Stellung stehen, wird die Basizität des Amin-Stickstoffs und damit die Reaktivität weiter herabgesetzt. DSC-Untersuchungen (Dynamic Scanning Calorimetry) zum reaktive Verhalten der mit HALS stabilisierten Epoxidharzkomponenten insbesondere auch nach Auslagerung der Harze bei 80°C belegen die Lagerfähigkeit. Sie beträgt bei 30°C überraschenderweise mehr alös 6 Monate.

In beschleunigten Alterungstests unter kurzwelliger Strahlung zwischen 360nm und 500nm sowie bei energiereicher Strahlung >420nm (UV-B-Filter) wurde die Wirksamkeit der HALS Stabilisatoren in Epoxid-Anhydrid-Formstoffen aufgezeigt.

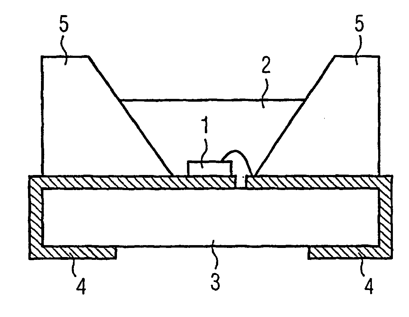

Figur 1 zeigt den schematischen Aufbau einer LED, die hier SMD-tauglich ausgebildet ist. Das Halbleiterbauelement 1, also die Diode selbst, ist auf einen Leadframe 4 montiert und mit diesem elektrisch verbunden. Das vorzugsweise aus Thermoplast bestehende Kunststoffgehäuse 3,5 mit dem transparenten Gießharz 2 bildet das SMD-Package, das das Bauelement vor widrigen Umgebungseinflüssen schützt und so die Funktionsfähigkeit über die Lebensdauer gewährleistet. Oberhalb der Gießharzverkapselung 2 kann anschließend noch eine optische Linse befestigt werden, falls eine zusätzliche Bündelung der Strahlung erwünscht ist.

### 1. Ausführungsbeispiel

Für die A-Komponente des ersten Ausführungsbeispiels werden folgende in Gewichtsprozent angegebenen Komponenten homogen miteinander vermischt:

| | |
|---|---|
| Bisphenol A Diglycidylether (Rütapox VE3748 - Fa. Bakelite) | 98,98 % |
| Entlüfter (BYK A-506, Fa. BYK Chemie) | 0,2 % |
| Haftvermittler (Silane A-187, Fa. ABCR GmbH) | 0,80 % |
| Optischer Aufheller (Masterbatch 09, CIBASCISIN) | 0,016 % |

Nach Umsetzung mit der genannten B-Komponente wird ein Formstoff erhalten, der eine Glasübergangstemperatur von 125 bis 126 Grad Celsius aufweist. Nach 6 Wochen Kaltwasserlagerung beträgt die Feuchtigkeitsaufnahme 0,65 Gewichtsprozent, wobei die damit verbundene Abnahme der Glasübergangstemperatur auf nur 124 Grad Celsius bemerkenswert niedrig ist. Der E-Modul (Tensile, 3 K/Minuten, 1 Hz) beträgt 2660 MPa. Der thermische Ausdehnungskoeffizient CTE (-50/+50°C) beträgt 59,7 ppm/K. Die Kaltwasseraufnahme nach einer Woche bei 23 °C beträgt 0,31 %.

Diese für sich bereits sehr guten thermisch mechanischen Eigenschaften sowie die hohe Feuchtigkeitsbeständigkeit wird auf den geringen Gehalt an Hydroxylgruppen des spezifischen Bisphenol-A- Diglycidylether Produktes (Rütapox VE 9748) zurückgeführt

### 2. Ausführungsbeispiel

Die A-Komponente des 2. Ausführungsbeispiels ist bezüglich der Epoxidkomponente gegenüber dem ersten Ausführungsbeispiel modifiziert. Sie weist folgende Zusammensetzung (angegeben in Gewichtsprozenten) auf:

| | |
|---|---|
| Bisphenol A-Diglycidylether (Rütapox VE3748) | 78,98 % |
| Epoxynovolakharz (D.E.N., DOW) | 20,00 % |
| Entlüfter (BYK A-506 (Entlüfter, **BYK Chemie**) | 0,20 % |
| Haftvermittler (Silane A-187, **ABCR GmbH**) | 0,80 % |
| Optischer Aufheller (Masterbatch 09, **CIBASCININ**) | 0,016 % |

Die A-Komponente gemäß dem Beispiel 2 wird mit der oben angegebenen B-Komponente umgesetzt. Aus den entsprechenden Formkörpern werden die thermomechanischen Eigenschaften bestimmt. Der Gießharzformstoff zeigt in Abhängigkeit von den Härtebedingungen eine Glasübergangstemperatur von bis zu 141°C. Nach 6 Wochen Lagerung im kalten Wasser beträgt die Feuchteaufnahme 0,67 %, wobei die Glasübergangstemperatur lediglich um 4 °C auf 137 °C abfällt. Der E-Modul (Tensile, 3 K/Minute, 1 Hz) beträgt 2570 MPa. Es wurde ein thermischer Ausdehnungskoeffizient CTE (- 50/+50°C) von 57,4 ppm/K ermittelt. Nach Lagerung in kaltem Wasser bei 23 °C für eine Woche wird eine Kaltwasseraufnahme von 0,36 % bestimmt.

### 3. Ausführungsbeispiel

Für dieses Beispiel wird die A-Komponente von Beispiel 1 mit 0,2 Gewichtsprozent eines sterisch gehinderten N-Oxyalkylamins (Tinuvin 123, CIBA Speciality) versetzt. Es wird eine lagerfähige A-Komponente mit nahezu unveränderten reaktivem Verhalten und nahezu unveränderter Glasübergangstemperatur im Formstoff erhalten. An damit vergossenen Leuchtdioden wird eine verbesserte Alterungsstabilität nach Einwirkung energiereicher elektromagnetischer Strahlung beobachtet, die alterungsbedingte Abnahme der Lichtintensität ist wesentlich besser als beim Beispiel 1.

### 4. Ausführungsbeispiel

Die im Beispiel 2 verwendete A-Komponente wird mit 0,1 Gewichtsprozent Tinuvin 123 (CIBA Speciality) versetzt. Auch hier wird eine lagerfähige A-Komponente mit nahezu unveränderten reaktivem Verhalten und nahezu unveränderter Glasübergangstemperatur des Formstoffs erhalten. Es ist eine verbesserte Alterungsbeständigkeit nach Einwirkung energiereicher elektromagnetischer Strahlung an damit vergossenen LEDs zu beobachten.

### 5. Ausführungsbeispiel

Die A-Komponente von Beispiel 2 wird mit 0,2 Gewichtsprozenten Tinuvin 123 (CIBA Speciality) versetzt und zusätzlich mit 0,3 % eines sterisch gehinderten Phenolderivats (Akcros Chemicals) versetzt. Es wird in etwa das gleiche Verhalten wie im Ausführungsbeispiel 4 gemessen, zusätzlich ist die Alterungsstabilität beziehungsweise die Oxydationsempfindlichkeit weiter erniedrigt.

Es zeigt sich also, daß mit den erfindungsgemäßen Epoxidharzsystemen Gießharzvergußmassen zur Verfügung stehen, die bestens zum Vergießen elektrischer und elektronischer Bauelemente geeignet sind, insbesondere solcher Bauelemente die einer hohen thermischen Beanspruchung, erhöhter Feuchteeinwirkung und Strahlenbelastung ausgesetzt sind. Die daraus hergestellten Formstoffe lassen sich mit hoher Glasübergangstemperatur herstellen und zeigen eine gegenüber bekannten Formstoffen verbesserte Alterungsbeständigkeit, insbesondere an Licht. Die hohe Glasübergangstemperatur macht sie insbesondere auch zur Verarbeitung in SMD Verfahren geeignet, da damit gekapselte Bauelemente eine Lötbehandlung unbeschädigt überstehen.

Die beschriebenen transparenten Formstoffe sind besonders für optoelektronische Bauelement geeignet. Aufgrund der hohen T_{g} finden die Epoxidharze auch Anwendungen beim Verguß von Bauelementen und Sensoren für den Automobilbereich. Wegen der guten Witterungsbeständigkeit hinsichtlich Temperatur, Feuchte und Strahlung eigene sich die Epoxidvergußmassen auch für Außenanwendungsbereich. Lacke und Preßmassen auf Epoxidharzbasis mit den HALS Stabilisatoren sind ebenfalls vorteilhaft und zeigen gegenüber entsprechenden bekannten Massen ohne die HALS Stabilisatoren die genannte verbesserte Strahlungs- und Witterungsbeständigkeit.

## Patentansprüche

1. Epoxidharzsystem, umfassend
- eine Epoxidhaltige A-Komponente, in der als Stabilisator gegen Formstoffalterung durch Strahlungseinflüsse eine sterisch gehinderte Aminoxidalkylverbindung der allgemeinen Zusammensetzung
(R1) (R2)N-R3
enthalten ist, wobei R1 und R2 unabhängig voneinander für Alkyl, Aryl oder Alkylaryl stehen, zusammen einen zweiwertigen Rest bilden oder zusammen mit dem N-Atom einen heterocyclischen Ring bilden und R3 einen Alkoxyrest mit 1-18 C-Atomen bedeutet, der zusätzlich noch eine oder zwei funktionelle Gruppen mit Ausnahme von NH aufweisen kann und
- ein Härter als B-Komponente.

2. Epoxidharzsystem nach Anspruch 1,
ausgebildet für Gießharzanwendungen,
bei dem die A-Komponente mehr als 60 Gewichtsprozent eines Epoxids auf Basis eines Glycidylethers oder Glycidylesters enthält und der Härter ein Anhydrid ist.

3. Epoxidharzsystem nach einem der Ansprüche 1-2, bei dem das sterisch gehinderte Amin in einem Anteil von 0,1 - 5,0 Gewichtsprozent in der A-Komponente enthalten ist.

4. Epoxidharzsystem nach einem der Ansprüche 1-3, bei dem die B-Komponente ein Anhydrid einer cycloaliphatischen oder aromatischen Di- oder Tetracarbonsäure als Hauptbestandteil und den entsprechenden mit aliphatischem Alkohol erhaltenen sauren Ester eines Anhydrids als Nebenbestandteil umfasst.

5. Epoxidharzsystem nach einem der Ansprüche 1-4, bei dem in der B-Komponente phosphororganische Oxidationsstabilisatoren und Beschleuniger enthalten sind.

6. Epoxidharzsystem nach einem der Ansprüche 1-5, bei dem als weiterer Stabilisator ein sterisch gehindertes Phenolderivat in der A-Komponente enthalten ist.

7. Epoxidharzsystem nach einem der Ansprüche 1-6, bei dem die A-Komponente als Hauptbestandteil einen Diglycidylether, einen Diglycidylester, ein cycloaliphatisches Epoxid oder Mischungen davon enthält.

8. Epoxidharzsystem nach einem der Ansprüche 1-7, bei dem die A-Komponente als Hauptbestandteil einen Diglycidylether von Bisphenol A und als Nebenbestandteil ein mehrfunktionelles Epoxynovolakharz in zusammen mehr als 80 Gewichtsprozent Anteil neben üblichen weiteren Zusätzen enthält.

9. Epoxidharzformstoff, hergestellt durch Härtung eines Epoxidharzsystems nach einem der Ansprüche 1-8, mit einer Glasübergangstemperatur von zumindest 130°C.

10. SMD Bauelement, vergossen mit einem Epoxidharzsystem nach einem der Ansprüche 1-8.

11. Optoelektronisches Bauelement mit einer im Strahlengang des Bauelements angeordneten und für die Strahlung transparenten Verkapselung aus einem Epoxidharzsystem nach einem der Ansprüche 1-7.

12. Bauelement nach Anspruch 11,
ausgebildet als Licht emittierende Diode - LED.

13. Bauelement nach Anspruch 12,
mit einer Emissionswellenlänge im blauen Spektralbereich unterhalb 500 nm.

14. Verwendung eines Formstoffs oder Bauelements nach einem der Ansprüche 9-13 im Automobilbereich für Außenanwendungen.

15. Verwendung eines Formstoffs oder Bauelements nach einem der Ansprüche 9-13 als Kapselung für Weißlicht LEDs.

16. Verwendung eines Epoxidharzsystems nach einem der
Ansprüche 1-8 zur Herstellung licht- und witterungsstabiler Lacksysteme.

17. Verwendung eines Epoxidharzsystems nach einem der Ansprüche 1-8 zur Herstellung strahlungs- und witterungsstabiler mit mineralischen Füllstoffen gefüllter Gießharzformstoffe oder Preßmassenformstoffe.

## Claims

1. Epoxy resin system, encompassing
- an epoxy-containing A component in which a sterically hindered alkoxyamine compound of the general composition
(R1) (R2)N-R3
is present as stabilizer to inhibit ageing of cured resin by the effects of radiation, where R1 and R2, independently of one another, are alkyl, aryl or alkylaryl, or together form a divalent radical, or together with the N atom form a heterocyclic ring, and R3 is an alkoxy radical having from 1 to 18 carbon atoms which may also have one or two functional groups other than NH and
- a hardener as B component.

2. Epoxy resin system according to Claim 1, designed for casting resin applications,
where the A component of the system comprises more than 60% by weight of an epoxide based on a glycidyl ether or glycidyl ester, and the hardener is an anhydride.

3. Epoxy resin system according to Claim 1 or 2,
where the proportion of the sterically hindered amine present in the A component of the system is from 0.1 to 5.0% by weight.

4. Epoxy resin system according to any one of Claims 1 to 3,
where the B component of the system encompasses, as main constituent, an anhydride of a cycloaliphatic or aromatic di- or tetracarboxylic acid, and encompasses, as ancillary constituent, the corresponding acidic ester, obtained with an aliphatic alcohol, of an anhydride.

5. Epoxy resin system according to any one of Claims 1 to 4,
where the B component of the system comprises organophosphorus antioxidants and accelerators.

6. Epoxy resin system according to any one of Claims 1 to 5,
where the A component of the system comprises a sterically hindered phenol derivative as further stabilizer.

7. Epoxy resin system according to any one of Claims 1 to 6,
where the A component of the system comprises, as main constituent, a diglycidyl ether, a diglycidyl ester, a cycloaliphatic epoxide, or a mixture thereof.

8. Epoxy resin system according to any one of Claims 1 to 7,
where the A component of the system comprises, as main constituent, a diglycidyl ether of bisphenol A, and comprises, as ancillary constituent, a polyfunctional epoxy novolac resin in, together, a proportion of more than 80% by weight, alongside conventional other additives.

9. Cured epoxy resin, produced via curing of an epoxy resin system according to any one of Claims 1 to 8, with a glass transition temperature of at least 130°C.

10. SMD component, potted with an epoxy resin system according to any one of Claims 1 to 8.

11. Optoelectronic component with encapsulation which is composed of an epoxy resin system according to any one of Claims 1 to 7 and which has been arranged in the beam path of the component and which is transparent to the radiation.

12. Component according to Claim 11,
designed as light-emitting diode - LED.

13. Component according to Claim 12,
with an emission wavelength in the blue region of the spectrum below 500 nm.

14. Use of a cured resin or component according to any one of Claims 9 to 13 in the automotive sector for exterior uses.

15. Use of a cured resin or component according to any one of Claims 9 to 13 as capsule for white-light LEDs.

16. Use of an epoxy resin system according to any one of Claims 1 to 8 one for production of coating systems resistant to light and to weathering.

17. Use of an epoxy resin system according to any one of Claims 1 to 8 for production of cured thermoset resins or cured casting resins filled with mineral fillers and resistant to radiation and to weathering.

## Revendications

1. Système de résines époxydes, comprenant un composant A contenant des époxydes, dans lequel est contenu, en tant qu'agent stabilisateur contre la modification d'un produit à demi moulé par les influences d'un rayonnement, un composé aminoxyalkyle, à encombrement stérique, de la composition générale
(R1) (R2)N-R3
R1 et R2 désignant indépendamment un radical alkyle, aryle ou alkylaryle, formant ensemble un radical divalent ou formant ensemble avec l'atome N un cycle hétérocyclique et R3 désignant un radical alkoxy ayant 1-18 atomes de C, qui peut, en outre, encore présenter un ou deux groupements fonctionnels à l'exception de NH et un agent de durcissement en tant que composant B.

2. Système de résines époxydes selon la revendication 1, conçu pour des applications à résine de coulée, pour lequel le composant A contient plus de 60 pour cent en poids d'un époxyde à base d'un éther glycidylique ou d'un ester glycidylique et pour lequel l'agent de durcissement est un anhydride.

3. Système de résines époxydes selon l'une quelconque des revendications 1-2, pour lequel l'amine à encombrement stérique est contenue dans une proportion de 0,1 - 5,0 pour cent en poids dans le composant A.

4. Système de résines époxydes selon l'une quelconque des revendications 1-3, pour lequel le composant B comprend, en tant que constituant principal, un anhydride d'un acide dicarboxylique ou tétracarboxylique, cycloaliphatique ou aromatique, et, en tant que constituant secondaire, l'ester acide correspondant d'un anhydride, obtenu à l'aide de l'alcool aliphatique.

5. Système de résines époxydes selon l'une quelconque des revendications 1-4, pour lequel le composant B contient des agents de stabilisation d'oxydation et des agents accélérateurs phosphore-organiques.

6. Système de résines époxydes selon l'une quelconque des revendications 1-5, pour lequel le composant A contient, en tant qu'agent de stabilisation supplémentaire, un dérivé du phénol à encombrement stérique.

7. Système de résines époxydes selon l'une quelconque des revendications 1-6, pour lequel le composant A contient, en tant que constituant principal, un éther diglycidylique, un ester diglycidylique, un époxyde cycloaliphatique ou des mélanges de ces derniers.

8. Système de résines époxydes selon l'une quelconque des revendications 1-7, pour lequel le composant A contient, en tant que constituant principal, un éther diglycidylique du bisphénol A et, en tant que constituant secondaire, une résine du type époxyde Novolaque à fonctions multiples dans une proportion constituant ensemble plus de 80 pour cent en poids, en sus des additifs usuels supplémentaires.

9. Pièce moulée en résine époxyde, fabriquée par durcissement d'un système de résines époxydes selon l'une quelconque des revendications, 1-8, ayant une température de transition vitreuse d'au moins 130°C.

10. Élément de construction SMD (Surface Mounted Device), coulé à l'aide d'un système de résines époxydes selon l'une quelconque des revendications 1-8.

11. Élément de construction opto-électronique ayant un encapsulage, fait d'un système de résines époxydes, selon l'une quelconque des revendications 1-7, disposé dans le trajet de rayonnement de l'élément de construction et transparent vis-à-vis du rayonnement.

12. Élément de construction selon la revendication 11, réalisé en tant que diode électroluminescente DEL.

13. Élément de construction selon la revendication 12, ayant une longueur d'onde d'émission dans le domaine spectral bleu en dessous de 500 nm.

14. Utilisation d'un produit à demi moulé ou d'un élément de construction selon l'une quelconque des revendications 9-13 dans le domaine de l'industrie automobile pour des applications externes.

15. Utilisation d'un produit à demi moulé ou d'un élément de construction selon l'une quelconque des revendications 9-13 en tant que capsulage pour des DEL à lumière blanche.

16. Utilisation d'un système de résines époxydes selon l'une quelconque des revendications 1-8 en vue de la fabrication de systèmes de vernis stables vis-à-vis de la lumière et des intempéries.

17. Utilisation d'un système de résines époxydes selon l'une quelconque des revendications 1-8 en vue de la fabrication de produits à demi moulés en résine de coulée ou en masses comprimées, remplis de charges minérales, stables vis-à-vis du rayonnement et des intempéries.
